(19) Europäisches Patentamt
European Patent Office
Office européen des brevets

(11) **EP 2 742 538 B1**

(12) **EUROPÄISCHE PATENTSCHRIFT**

(45) Veröffentlichungstag und Bekanntmachung des Hinweises auf die Patenterteilung:
**05.05.2021   Patentblatt 2021/18**

(21) Anmeldenummer: **12772428.4**

(22) Anmeldetag: **16.07.2012**

(51) Int Cl.:
**H01L 31/0747** *(2012.01)*     **H01L 31/18** *(2006.01)*

(86) Internationale Anmeldenummer:
**PCT/IB2012/053626**

(87) Internationale Veröffentlichungsnummer:
**WO 2013/021298 (14.02.2013 Gazette 2013/07)**

(54) **VERFAHREN ZUR HERSTELLUNG EINER SOLARZELLE**

METHOD FOR PRODUCING A SOLAR CELL

PROCÉDÉ DE FABRICATION D'UNE CELLULE PHOTOVOLTAÏQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.08.2011   DE 102011052480**

(43) Veröffentlichungstag der Anmeldung:
**18.06.2014   Patentblatt 2014/25**

(73) Patentinhaber: **Meyer Burger (Germany) GmbH 09337 Hohenstein-Ernstthal (DE)**

(72) Erfinder:
- **STRAHM, Benjamin**
  **1429 Giez (CH)**
- **LACHENAL, Damien**
  **2022 Bevaix (CH)**
- **GUERIN, Chloé**
  **38000 Grenoble (FR)**
- **DESCOEUDRES, Antoine**
  **1007 Lausanne (CH)**
- **DE WOLF, Stefaan**
  **9900 Eeklo (BE)**
- **BARRAUD, Loris**
  **2300 La Chaux-de-Fonds (CH)**

(74) Vertreter: **Steiniger, Carmen Patentanwaltskanzlei Dr. Steiniger Reichsstraße 37 09112 Chemnitz (DE)**

(56) Entgegenhaltungen:
**WO-A2-2012/085155**

- **FUJIWARA H ET AL: "Optimization of interface structures in crystalline silicon heterojunction solar cells", SOLAR ENERGY MATERIALS AND SOLAR CELLS, ELSEVIER SCIENCE PUBLISHERS, AMSTERDAM, NL, Bd. 93, Nr. 6-7, 7. November 2008 (2008-11-07), Seiten 725-728, XP026093494, ISSN: 0927-0248, DOI: 10.1016/J.SOLMAT.2008.09.007 [gefunden am 2008-11-07]**
- **HIROYUKI FUJIWARA ET AL: "Interface Structure in a-Si:H/c-Si Heterojunction Solar Cells Characterized by Optical Diagnosis Technique", CONFERENCE RECORD OF THE 2006 IEEE 4TH WORLD CONFERENCE ON PHOTOVOLTAIC ENERGY CONVERSION (IEEE CAT. NO.06CH37747), IEEE, Mai 2006 (2006-05), Seiten 1443-1448, XP031007590, ISBN: 978-1-4244-0016-4**
- **J. MITCHELL: "Surface Passivation of Multi-Crystalline Silicon by Multi-Layer Deposition of Hydrogenated Amorphous Silicon", PROCEEDINGS OF THE 24TH EUROPEAN PHOTOVOLTAIC SOLAR ENERGY CONFERENCE, 21. September 2009 (2009-09-21), - 25. September 2009 (2009-09-25), Seiten 1569-1573, XP040529988, DOI: 10.4229/24thEUPVSEC2009-2CV.2.45 ISBN: 978-3-936338-25-6**

- **MAN-CHI HUANG ET AL: "The effect of H 2 treatment on heterojunction with intrinsic thin layer (HIT) solar cell perfromance using 40.68MHz VHF-PECVD system", PHOTOVOLTAIC SPECIALISTS CONFERENCE (PVSC), 2011 37TH IEEE, IEEE, 19. Juni 2011 (2011-06-19), Seiten 3001-3004, XP032168318, DOI: 10.1109/PVSC.2011.6186575 ISBN: 978-1-4244-9966-3**
- **MUELLER T ET AL: "Investigation of the emitter band gap widening of heterojunction solar cells by use of hydrogenated amorphous carbon silicon alloys", JOURNAL OF APPLIED PHYSICS, AMERICAN INSTITUTE OF PHYSICS. NEW YORK, US, Bd. 102, Nr. 7, 4. Oktober 2007 (2007-10-04), Seiten 74505-74505, XP012101971, ISSN: 0021-8979, DOI: 10.1063/1.2785012**
- **DESCOEUDRES A ET AL: "Improved amorphous/crystalline silicon interface passivation by hydrogen plasma treatment", APPLIED PHYSICS LETTERS, AIP, AMERICAN INSTITUTE OF PHYSICS, MELVILLE, NY, US, Bd. 99, Nr. 12, 19. September 2011 (2011-09-19), Seiten 123506-123506, XP012153111, ISSN: 0003-6951, DOI: 10.1063/1.3641899 [gefunden am 2011-09-23]**

**Beschreibung**

Die vorliegende Erfindung betrifft ein Verfahren zur Herstellung einer Solarzelle mit einem kristallinen Siliziumkern, wenigstens einer n- oder p-dotierten Silizium- oder Siliziumlegierungsschicht und wenigstens einer aus Silizium- oder einer Siliziumlegierung bestehenden Passivierungsschicht zwischen wenigstens einer Oberfläche des Siliziumkerns und der wenigstens einen n- oder p-dotierten Silizium- oder Siliziumlegierungsschicht.

Solarzellen sind Halbleiterbauelemente, in denen einfallendes Licht Elektronen-Loch-Paare erzeugt. Die durch die Lichtstrahlung erzeugten Ladungsträger, d. h. die freien Elektronen und die Löcher, werden durch in der Solarzelle ausgebildete elektrische Felder zu äußeren Anschlusselektroden geleitet und an diesen äußeren Elektroden für elektrische Verbraucher bereit gestellt. Für die Ausbildung eines elektrischen Feldes in der Solarzelle werden wenigstens eine p-dotierte und eine n-dotierte Halbleiterschicht benötigt. In hochentwickelten Solarzellen kommen jedoch teilweise auch weitere Schichten, wie beispielsweise zweite p- und n-leitende Schichten, zur Ausbildung von zweiten p-n-Übergängen in Tandemsolarzellen oder hochdotierte Rückseitenschichten, welche elektrische Felder zu Rückseitenelektroden hin bewirken, zum Einsatz.

Um eine effektive Umwandlung von Lichtenergie in elektrische Energie in einer Solarzelle zu erreichen, ist es wichtig, dass die in der Solarzelle erzeugten Ladungsträger in der Solarzelle mit möglichst geringer Wahrscheinlichkeit rekombinieren. Unter Rekombination wird die Wiedervereinigung von Elektronen und Löchern verstanden, bei der die getrennten Ladungsträger für eine Nutzung außerhalb der Solarzelle verloren gehen. Die Rekombination von Ladungsträgern erfolgt bevorzugt an sogenannten Rekombinationszentren, was beispielsweise ungesättigte Bindungen an Störstellen in einem Halbleiterkristall oder an Korngrenzen in abgeschiedenen Schichten sein können. Die Rekombinationszentren bewirken aber nicht nur eine Reduzierung des Photostroms durch die Reduzierung von Ladungsträgern, sondern sie wirken auch als Störstellen in der Bandlücke des Solarzellenhalbleiters und bewirken dadurch eine Verschlechterung von wichtigen Kenngrößen der Solarzelle, wie beispielsweise eine Erhöhung des Dunkelstroms und eine Reduzierung der Leerlaufspannung (open circuit voltage ($V_{oc}$)). So sind beispielsweise aus den Druckschriften EP 1 460 693 B1 und US 7,030,413 B2 sogenannte Silizium-Heterojunction-Solarzellen bekannt, bei welchen sehr dünne intrinsische amorphe wasserstoffhaltige Siliziumzwischenschichten (a-Si:H-Schichten) in einem p-n-Hetero-Übergang zwischen einem kristallinen Siliziumsubstrat bzw. Siliziumkern (c-Si) und einer amorphen, invers zu dem Siliziumkern dotierten Schicht eine Verbesserung wichtiger Solarzellenparameter bewirken können. Die a-Si:H-Schichten werden typischerweise mittels plasmagestützter chemischer Gasphasenabscheidung (PECVD) oder ähnlichen Verfahren abgeschieden.

Um eine hohe Leerlaufspannung und damit eine hohe Effizienz einer Solarzelle zu erzielen, muss die Passivierung der Waferoberflächen des kristallinen Siliziumsubstrates (c-Si) durch die dünnen intrinsischen a-Si:H-Schichten so gut wie möglich sein. Eine a-Si:H-Schicht passiviert eine c-Si-Oberfläche hauptsächlich durch Hydrierung offener Silizium-Bindungsstellen (dangling bonds), was zu einer Verringerung der Grenzflächendefektdichte führt.

Um eine bessere Passivierung zu erreichen, wurde beispielsweise durch Hyun Jin Yang, Kwang-sun Ji, Junghoon Choi und Heon Min Lee in ihrem Artikel "Annealing effect on surface passivation of a-Si:H/c-Si interface in terms of crystalline volume fraction", Current Applied Physics 10 (2010) S375-S378 vorgeschlagen, auf n-dotiertem kristallinen Siliziumsubstrat (c-Si) abgeschiedene intrinsische a-Si:H-Schichten nachfolgend zu tempern, wodurch eine Aktivierung und Umordnung des mobilen Wasserstoffs in den a-Si:H-Schichten hin zu der Grenzfläche zwischen kristallinem Substrat und amorpher Schicht erfolgt, wo der Wasserstoff an den offenen Bindungen (dangling bonds) des kristallinen Siliziums getrappt wird und hierdurch eine bessere Passivierung des kristallinen Siliziums erfolgt.

Die Entwicklung von Solarzellen ist jedoch noch nicht abgeschlossen, sondern es wird eine weitere Verbesserung und Effizienzsteigerung von Solarzellen benötigt.

In dem Artikel von Fujiwara et al. "Optimization of interface structures in crystalline silicon heterojunction solar cells", Solar Energy Materials & Solar Cells 93 (2009), S. 725 - 728 ist eine Schichtfolge aus einem undotierten kristallinen Siliziumsubstrat und einer direkt darauf befindlichen a-SiO:H-i-Schicht beschrieben, wobei mit ATR-Spektroskopie unter anderem die SiH-Anteile mit 3,7 at.% und die $SiH_2$-Anteile mit 12,4 at.% in der a-SiO:H-i-Schicht bestimmt wurden. Des Weiteren sind in diesem Artikel gemessene Effektivitätswerte einer Vielzahl von auf unterschiedliche Weise hergestellten Solarzellen in Abhängigkeit von der jeweils verwendeten RF-Leistungsdichte und der verwendeten Abscheidungstemperatur aufgeführt.

Der Artikel von Fujiwara et al. "Interface structure in a-Si:H/C-Si heterojunction solar cells characterized by optical diagnosis technique", Conference Record of the 2006 IEEE 4th World Conference on Photovoltaic Energy Conversion, IEEE, Mai 2006, S. 1443 - 1448 befasst sich mit der Grenzflächenstruktur in a-Si:H/c-Si-Solarzellen. Mittels ATR-Spektroskopie wurde an einer auf einem Si(100)-Substrat ausgebildeten a-Si:H p-i-Schichtformation eine hohe Konzentration von $SiH_2$-Bindungen in der a-Si:H i-Schicht festgestellt. Ferner sind in diesem Artikel Ausführungen zum Einfluss der jeweils verwendeten Abscheidungstemperatur auf die Solarzelle enthalten.

In dem Artikel von J. Mitchell "Surface passivation of multi-crystalline silicon by multilayer deposition of hydrogenated amorphous silicon", Proceedings of the 24th European Photovoltaic Solar Energy Conference, 21.-25. September 2009, S. 1569 - 1573 wird multikristallines n- oder p-dotiertes Silizium durch CVD-Multilagen-Abscheidung von wasserstoffhaltigem amorphen Silizium, das heißt, durch aufeinanderfolgende Abscheidung von sehr dünnen intrinsischen a-Si:H-Schichten, oberflächenpassiviert. Zwischen n- oder p-dotierten a-Si:H-Schichten können jeweils dünne a-Si:H(i)-Zwischenschichten vorgesehen sein. Die einzelnen a-Si:H-Subschichten wurden stets auf gleiche Weise mit PECVD bei 225 °C abgeschieden.

In dem Artikel von Man-Chi Huang et al. "The effect of H2 treatment on heterojunction with intrinsic thin layer (HIT) solar cell performance using 40.68 MHz VHF-PECVD system", 37th Photovoltaic Specialists Conference, 19. Juni 2011, S. 3001 - 3004 wurden zur Ausbildung von HIT-Solarzellen verwendete dünne amorphe Siliziumschichten mit Wasserstoffplasma behandelt, wodurch die Solarzellencharakteristik verbessert wurde.

Der Artikel von T. Mueller et al. "Investigation of the emitter band gap widening of heterojunction solar cells by use of hydrogenated amorphous carbon silicon alloys", Journal of Applied Physics, Bd. 102, Nr. 7, 4. Oktober 2007, S. 74505 beschäftigt sich mit der Einbindung von Wasserstoff und Kohlenstoff in $[a\text{-}Si_xC_{1-x}(n){:}H_y]$ - und $[a\text{-}Si_x(n){:}H_y]$-Schichten.

Es ist daher die Aufgabe der vorliegenden Erfindung, ein Verfahren zur Herstellung einer Solarzelle bereit zu stellen, die sich durch eine vergrößerte Leerlaufspannung auszeichnet.

Die Solarzelle zeichnet sich dadurch aus, dass die Passivierungsschicht Silizium-Mono-Hydrid-Molekülgruppen (Si-H) und Silizium-Di-Hydrid-Molekülgruppen (Si-H$_2$) aufweist, wobei ein Verhältnis (Q) der Anzahl von Silizium-Di-Hydrid-Molekülgruppen ($n_{Si-H2}$) zu der Gesamtanzahl von Silizium-Di-Hydrid-Molekülgruppen und Silizium-Mono-Hydrid-Molekülgruppen ($n_{Si-H}$) + ($n_{Si-H}$) in einem Vergleichsvolumen der Passivierungsschicht größer als 0,4 ist

$$\left( Q = \frac{n_{Si-H2}}{n_{Si-H2} + n_{Si-H}} > 0,4 \right).$$

Überraschenderweise wurde herausgefunden, dass es in der Passivierungsschicht nicht genügt, Wasserstoff in der aus dem Stand der Technik überlieferten Form von Silizium-Mono-Hydrid-Molekülgruppen bereit zu stellen. In der Solarzelle werden die vorteilhaften Wirkungen einer wasserstoffhaltigen Passivierungsschicht durch die Bereitstellung von Wasserstoff in Form von Silizium-Di-Hydrid-Molekülgruppen gegenüber den aus dem Stand der Technik bekannten Passivierungsschichten mit Silizium-Mono-Hydrid-Molekülgruppen deutlich erhöht. Die Herstellung von Silizium-Di-Hydrid-Molekülgruppen erfordert hochentwickelte, spezielle Herstellungsverfahren. Mit versuchsweise verwendeten Herstellungsverfahren wurden Schichten hergestellt, bei denen Wasserstoff sowohl in Silizium-Mono-Hydrid- als auch in Silizium-Di-Hydrid-Molekülgruppen vorlag. Die elektrische Charakterisierung von Solarzellen, in denen Passivierungsschichten mit verschiedenen Konzentrationen von Silizium-Di-Hydrid-Molekülgruppen und Silizium-Mono-Hydrid-Molekülgruppen getestet wurden, hat ergeben, dass es günstig ist, die Grenzflächen mit einem Verhältnis der Anzahl von Silizium-Di-Hydrid-Molekülgruppen zu der Gesamtanzahl von Silizium-Di-Hydrid-Molekülgruppen und Silizium-Mono-Hydrid-Molekülgruppen von größer als 0,4 auszubilden. Eine obere Grenze für die Konzentration von Silizium-Di-Hydrid-Molekülgruppen ist hierbei nicht vorgesehen, sodass Wasserstoff in der Passivierungsschicht im Extremfall erfindungsgemäß auch nur in Silizium-Di-Hydrid-Molekülgruppen gebunden sein kann, wobei in diesem Spezialfall und das Verhältnis von Silizium-Di-Hydrid- zu Silizium-Mono-Hydrid-Molekülgruppen dann gleich 1 ist. Ein großer Anteil von Silizium-Di-Hydrid-Molekülgruppen ist ein Maß für eine hohe Qualität der Schichten. Deshalb wird das Verhältnis von Silizium-Di-Hydrid- zu allen Silizium-Di-Hydrid- und Silizium-Mono-Hydrid-Molekülgruppen vorliegend auch als Qualitätsfaktor oder Q-Faktor bezeichnet. In Experimenten wurden gute Solarzellen hergestellt, an denen Q-Faktoren von 0,57; 0,6 oder 0,63 gemessen worden sind, daher ist ein Q-Faktor > 0,57 besonders bevorzugt.

Zur Messung der Konzentration von Silizium-Hydrid-Molekülgruppen hat sich unter Laborbedingungen die Infrarotspektroskopie, beispielsweise als abgeschwächte Totalreflexionsmessung, bewährt. Beispielsweise haben Silizium-Mono-Hydrid-Molekülgruppen eine Absorptionslinie zwischen 1980 cm$^{-1}$ und 2020 cm$^{-1}$ und Silizium-Di-Hydrid-Molekülgruppen haben eine Absorptionslinie zwischen 2080 cm$^{-1}$ und 2120 cm$^{-1}$. Der Q-Faktor, der erfindungsgemäß zur Charakterisierung der Passivierungsschicht verwendet wird, kann aus einem Infrarotabsorptionsspektrum bestimmt werden. Zur Charakterisierung von Passivierungsschichten können jedoch auch andere direkte oder indirekte Messmethoden zum Einsatz kommen. Andere Messmethoden sind beispielsweise die hochauflösende Sekundär-Ionen-Massenspektroskopie (SIMS), die Auger-Elektronen-Spektroskopie (AES), die Spektralellipsometrie, die diffuse Reflexions-Infrarot-Fourier-Transformations-Spektroskopie (DRIFTS), die Ramanspektroskopie, die Elastic-Recoil-Detection (ERDS), die Nukleare-Reaktions-Analyse (NRA), die Elektronenspektroskopie für chemische Analysen (ESCA) oder rastermikroskopische Methoden.

In einer Weiterbildung der Solarzelle weist die n- oder p-dotierte Silizium- oder Siliziumlegierungsschicht und/oder die Passivierungsschicht Kohlenstoffatome in Si-C-Bindungen auf. Insbesondere auf der Seite der Solarzelle, in die der Einfall von Solarstrahlung vorgesehen ist, hat es sich als vorteilhaft erwiesen, Schichten mit einer größeren Bandlücke als Silizium einzusetzen. Erfolgreich getestete Schichten sind beispielsweise Siliziumkarbidschichten oder Siliziumschichten, die Kohlenstoff in Siliziumkarbidbindungen enthalten. Die mit dem Vorhandensein von Siliziumkarbidbindungen verbundene geringere optische Absorption führt dazu, dass mehr Licht bis zu dem kristallinen Siliziumkern in die Solarzelle eindringt und dadurch effektiver genutzt werden kann. Diese Eigenschaft ist nicht nur für die an der Ausbildung des pn- oder pin-Überganges beteiligte p- oder n-dotierte Silizium- oder Siliziumlegierungsschicht günstig, sondern auch für die Passivierungsschicht. Die Konzentration von Kohlenstoffatomen in den Schichten kann dabei auch Gradienten aufweisen.

In einer anderen Ausgestaltung der Solarzelle weist die n- oder p-dotierte Silizium- oder Siliziumlegierungsschicht und/oder die Passivierungsschicht Sauerstoffatome in Si-O-Bindungen auf. Die Herstellung von Silizium-Monoxid-Bindungen führt ebenfalls zu einer größeren Bandlücke im Vergleich zu Siliziumschichten und zu einer größeren optischen Transparenz dieser Schichten. Eine Sauerstoffdotierung kommt dabei nicht nur für die n- oder p-dotierten Silizium- oder Siliziumlegierungsschicht in Frage, sondern auch für die Passivierungsschicht. Es sind auch Schichten möglich, bei denen sowohl Siliziumkohlenstoff- als auch Siliziumsauerstoffbindungen vorgesehen sind. Dabei können für Kohlenstoff- und Sauerstoffatome unterschiedliche Gradienten vorgesehen sein, beispielsweise um elektrische Leitfähigkeitsanforderungen, optische Transparenzanforderungen und Kristallinitätsanforderungen optimal erfüllen zu können.

In verschiedenen Ausbildungen der Solarzelle ist die wenigstens eine n- oder p-dotierte Silizium- oder Siliziumlegierungsschicht und/oder die Passivierungsschicht eine amorphe, eine protokristalline, eine nanokristalline oder eine mikrokristalline Schicht. Die Kristallinität der eingesetzten Schichten hat verschiedene Einflüsse auf elektrische Kenngrößen von Solarzellen und auf die Degradation der Solarzellen. Eine bestimmte Kristallinität ist dabei in der Regel nicht generell gut oder schlecht, sondern mit verschiedenen Vor- und Nachteilen verbunden. Die Auswahl einer bestimmten Kristallinität ist dabei typischerweise die Festlegung eines Kompromisses zwischen den verschiedenen Vor- und Nachteilen. Vorteile amorpher Schichten sind beispielsweise eine hohe optische Transparenz und eine geringe Störstellendichte, verbunden mit einer großen anfänglichen elektrischen Effektivität. Nachteilig ist hingegen die starke Degradation dieser Schichten, die zu einem starken Leistungsabfall von Solarzellen beim langjährigen Einsatz der Solarzellen führen kann. Manche Eigenschaften von Schichten, die beispielsweise die optische Transparenz, die vor allem auf der Vorderseite der Solarzellen, in die das Licht einfällt, wichtig ist, sind jedoch auf der Rückseite der Solarzelle nicht oder weniger bedeutsam. Daher kann es möglich sein, dass für eine Vorderseitenschicht der Solarzelle eine andere Kristallinität als für eine Schicht auf der Rückseite der Solarzelle optimal ist.

In einer vorteilhaften Ausführungsform der Solarzelle ist die wenigstens eine Passivierungsschicht eine intrinsische Schicht. Intrinsisch bedeutet dabei, dass die Schicht nicht bei der Herstellung der Solarzelle gezielt p- oder n-dotiert wird. Die Passivierungsschicht kann dabei eine sehr dünne Schicht von nur wenigen Atomlagen und einer Dicke von einigen Angström oder wenigen Nanometern sein, die in einem Übergangsbereich zwischen einem n-leitenden und einem p-leitenden Gebiet vorgesehen ist. Trotz der Einfügung der undotierten Passivierungsschicht kann der pn-Übergang bessere Eigenschaften als ein pn-Übergang ohne zwischengelagerte Passivierungsschicht aufweisen. Es sind auch Solarzellen mit einem sogenannten pin-Übergang bekannt, bei denen zwischen einer n-leitenden- und einer p-leitenden-Schicht eine dicke intrinsische Schicht vorgesehen ist, in der ein wesentlicher Teil der Solarstrahlung absorbiert und zur Erzeugung von Elektronen-Loch-Paaren genutzt wird. Bei einem solchen Solarzellentyp kann die Silizium-Di-Hydrid-reiche Passivierungsschicht entweder selbst die gesamte intrinsische Schicht ausbilden oder sie kann auch eine oder beide Passivierungsschichten zwischen den p- oder n-dotierten Silizium- oder Siliziumlegierungsschichten und der intrinsischen Schicht ausbilden.

In anderen Varianten der Solarzelle ist die wenigstens eine Passivierungsschicht eine zumindest teilweise dotierte Schicht. Die Passivierungsschicht muss nicht zwingend als undotierte Schicht abgeschieden werden. Es ist auch möglich, die Passivierungsschicht p- oder n-dotiert abzuscheiden oder nach der Abscheidung, beispielsweise durch Diffusion mit Akzeptoren oder mit Donatoren zu dotieren. Dadurch entsteht eine p- oder n-dotierte Passivierungsschicht, die reich an Silizium-Di-Hydrid-Bindungen ist. In verschiedenen Solarzellen ist die Passivierungsschicht nur auf Teilflächen dotiert, beispielsweise werden bei manchen Solarzellen in dem Kontaktbereich zu Elektroden stärkere Dotierungen als sogenannte selektive Emitter erzeugt. Dabei ist es möglich, dass im Zuge der Herstellung dieser lokal dotierten Gebiete auch eine lokale Dotierung der Passivierungsschicht erfolgt.

Die Aufgabe der Erfindung wird gemäß der vorliegenden Erfindung durch ein Verfahren zur Herstellung einer Solarzelle der oben genannten Gattung gelöst, das sich dadurch auszeichnet, dass die Passivierungsschicht in mehreren Teilschritten eines Plasmaentladungsprozesses derart abgeschieden wird, dass die produzierte Passivierungsschicht Silizium-Mono-Hydrid-Molekülgruppen (Si-H) und Silizium-Di-Hydrid-Molekülgruppen (Si-H$_2$) aufweist und ein Verhältnis (Q) der Anzahl von Silizium-Di-Hydrid-Molekülgruppen ($n_{Si-H2}$) zu der Gesamtanzahl von Silizium-Di-Hydrid-Molekülgruppen und Silizium-Mono-Hydrid-Molekülgruppen ($n_{Si-H2}+n_{Si-H}$) in einem Vergleichsvolumen größer als 0,4 ist $\left( Q = \frac{n_{Si-H2}}{n_{Si-H2}+n_{Si-H}} > 0,4 \right)$, wobei die Passivierungsschicht in mehreren Teilschritten eines Plasmaentladungsprozesses abgeschieden wird, und wobei in einer ersten Variante des Verfahrens bei der Abscheidung der Passivierungsschicht eine alternierende Abfolge von Silan-Plasmaabscheidungsschritten und $H_2$-Plasmabehandlungsschritten angewendet wird oder

in einer zweiten Variante des Verfahrens bei der Abscheidung der Passivierungsschicht während aller Teilschritte des Plasmaentladungsprozesses ein kontinuierlich brennendes auf die Passivierungsschicht einwirkendes Plasma verwendet wird und in einem Folge-Teilschritt des Plasmaentladungsprozesses zur Abscheidung der Passivierungsschicht, der einem Vorgänger-Teilschritt dieses Plasmaentladungsprozesses folgt, wenigstens ein veränderbarer Abscheideparameter, ausgewählt aus den Abscheideparametern Prozessdruck, elektrische Leistung und Präkursorgasfluss, im Vergleich zu dem jeweils entsprechenden Abscheidungsparameter des Vorgänger-Teilschrittes geändert wird.

Zur Herstellung der Passivierungsschicht wird also ein hochentwickeltes Plasmaabscheidungsverfahren eingesetzt, das mehrere Teilschritte aufweist. Mit diesem Verfahren ist es möglich, in der Passivierungsschicht Silizium-Di-Hydrid-Molekülgruppen zu erzeugen. Dabei wird ein großer Teil des in die Passivierungsschicht eingebauten Wasserstoffes in Silizium-Di-Hydrid-Molekülgruppen bereit gestellt, was daran messbar ist, dass das Verhältnis der Anzahl von Silizium-Di-Hydrid-Molekülgruppen zu der Gesamtanzahl von Silizium-Di-Hydrid-Molekülgruppen und Silizium-Mono-Hydrid-Molekülgruppen größer als 0,4 ist. Die Messung der Anzahl der Silizium-Mono-Hydrid-Molekülgruppen erfolgt je nach verwendeten Messverfahren auf einer bestimmten Probefläche, die multipliziert mit der Schichtdicke ein Probenvolumen ergibt. Dieses Probenvolumen ist das Vergleichsvolumen, in dem die Messwerte gewonnen werden und zueinander in ein Verhältnis gestellt werden.

In einer Weiterbildung des Verfahrens wird bei der Abscheidung der n- oder p-dotierten Silizium- oder Siliziumlegierungsschicht und/oder der Passivierungsschicht wenigstens zeitweise ein Kohlenstoffpräkursor eingesetzt, wobei durch den Einsatz des Kohlenstoffpräkursors die erzeugte n- oder p-dotierte Silizium- oder Siliziumlegierungsschicht und/oder die erzeugte Passivierungsschicht Kohlenstoffatome in SiC-Bindungen aufweist. Während in der Grundvariante des Verfahrens die n- oder p-dotierte Silizium- oder Siliziumlegierungsschicht und/oder die Passivierungsschicht in Form von hydrogenisiertem Silizium abgeschieden wird, wird in dieser Weiterbildung des Verfahrens auch Kohlenstoff in die Schicht mit eingebaut, sodass Siliziumkarbid (SiC) oder eine Schicht mit Siliziumkarbidbindungen entsteht. Der Kohlenstoff wird als Kohlenstoffpräkursor zunächst in der Gasphase bereit gestellt. Ein gebräuchlicher Kohlenstoffpräkursor ist beispielsweise Methan. Durch den Einbau von Kohlenstoffbindungen in die Schicht(en) wird eine größere Bandlücke erreicht, die sich günstig auf die elektrischen Eigenschaften der hergestellten Solarzelle auswirken kann. Besonders günstig ist die Verwendung einer Schicht mit einer gegenüber Silizium vergrößerten Bandlücke auf der Vorderseite der Solarzelle, die der Solarstrahlung ausgesetzt ist. Schichten mit einer großen Bandlücke können jedoch auch auf der Rückseite der Solarzelle Verwendung finden, das kann beispielsweise aus Gründen einer einfachen und kostengünstigen Fertigung mit einer zweiseitigen Beschichtung in einem einzigen Abscheideprozess günstig sein.

In einem anderen Ausführungsbeispiel des erfindungsgemäßen Verfahrens wird bei der Abscheidung der n- oder p-dotierten Silizium- oder Siliziumlegierungsschicht und/oder der Passivierungsschicht wenigstens zeitweise ein Sauerstoffpräkursor eingesetzt, wobei durch den Einsatz des Sauerstoffpräkursors die erzeugte n- oder p-dotierte Silizium- oder Siliziumlegierungsschicht und/oder die erzeugte Passivierungsschicht Sauerstoffatome in Si-O-Bindungen aufweist. Siliziummonoxid ist ein optisch transparentes und leitfähiges Material mit einer großen Bandlücke. Daher kann Siliziummonoxid oder sauerstoffdotiertes Silizium mit Siliziummonoxid-Bindungen vorteilhaft zur Herstellung von Solarzellen eingesetzt werden.

Das erfindungsgemäße Verfahren ist gemäß einem Aspekt der Erfindung so ausführbar, dass bei der Abscheidung der Passivierungsschicht eine alternierende Abfolge von Silan-Plasmaabscheidungsschritten und $H_2$-Plasmabehandlungsschritten angewendet wird. In dieser Ausgestaltung des erfindungsgemäßen Verfahrens wird die Plasmaentladung zwischen den einzelnen Teilschritten kurz unterbrochen. Durch diese Vorgehensweise, bei welcher zwischenzeitlich immer wieder eine Wasserstoffbehandlung der abgeschiedenen Lagen der zu erzeugenden Passivierungsschicht erfolgt, wird der Gesamtwasserstoffgehalt der Passivierungsschicht als auch das Verhältnis von $SiH_2$ zu SiH in der Schicht gegenüber einfachen Silan-Plasmaschichtabscheidungen erhöht. Dies führt wiederum zu einer Erhöhung der Minoritätsträgerlebensdauer in der abgeschiedenen Passivierungsschicht, bedingt durch die gute Hydrierung der Grenzfläche zwischen kristallinem Siliziumsubstrat und amorpher Passivierungsschicht, welche schon vor bzw. schon zu Beginn einer nachfolgenden Temperung vorhanden ist.

In der zweiten Variante des erfindungsgemäßen Verfahrens wird bei der Abscheidung der Passivierungsschicht während aller Teilschritte des Plasmaentladungsprozesses ein kontinuierlich brennendes auf die Passivierungsschicht einwirkendes Plasma verwendet. Das heißt, in dieser Ausführungsform des erfindungsgemäßen Verfahrens wird die Plasmaentladung während der Schichtabscheidung auch dann, wenn Parameter der Schichtabscheidung zwischenzeitlich geändert werden, nicht unterbrochen. Durch plasmaunterstützte Abscheidungen kann eine effektive Aktivierung und Umsetzung der zur Schichtabscheidung eingesetzten Präkursoren bei relativ niedrigen Temperaturen erfolgen. Wegen der qualitativ hochwertigen und dabei kostengünstigen Abscheidung in plasmagestützten Prozessen werden diese bevorzugt für die Herstellung von Solarzellen eingesetzt. Bei der Abscheidung einer Schicht in mehreren Teilschritten wird dabei das Plasma üblicherweise in bestimmten Teilschritten gezündet und in anderen Teilschritten abgeschaltet. In der bevorzugten Variante des erfindungsgemäßen Verfahrens brennt das Plasma jedoch kontinuierlich über mehrere aufeinander folgende Teilschritte. Durch den kontinuierlichen Betrieb des Plasmas werden größere statistische Streuungen der Bewegungen von Teilchen aus dem Plasma vermieden. Mit dem gut definierten, kontinuierlich brennenden Plasma können gezielt die an Silizium-Di-Hydrid reichen Passivierungsschichten hergestellt werden.

In der zweiten Variante des erfindungsgemäßen Verfahrens wird in einem Folge-Teilschritt des Plasmaentladungsprozesses zur Abscheidung der Passivierungsschicht, der einem Vorgänger-Teilschritt dieses Plasmaentladungsprozesses folgt, wenigstens ein veränderbarer Abscheideparameter, ausgewählt aus den Abscheideparametern Prozessdruck, elektrische Leistung und Präkursorgasfluss, im Vergleich zu dem jeweils entsprechenden Abscheidungsparameter des Vorgänger-Teilschrittes geändert. Die verschiedenen Teilschritte in dem Abscheideverfahren unterscheiden sich durch wenigstens einen geänderten Abscheideparameter. Wenigstens einer der Abscheideparameter ist also in einem Folge-Teilschritt anders als in einem Vorgänger-Teilschritt. Wichtige Abscheideparameter, die Einfluss auf die hergestellten Schichten haben und damit zur gezielten Einstellung bestimmter Schichteigenschaften genutzt werden können, sind der Prozessdruck, die elektrische Leistung zur Herstellung des Plasmas und der Präkursorgasfluss, der im Zusammenspiel mit anderen Präkursorgasflüssen beispielsweise Einfluss auf die Zusammensetzung der Abscheideatmosphäre hat. In den verschiedenen Teilschritten können verschiedene Wirkungen auf die hergestellte Schicht erzeugt werden. Beispielsweise kann in einem ersten Teilschritt eine Oberflächenkonditionierung, in einem zweiten Teilschritt eine Abscheidung auf eine konditionierte Oberfläche und in einem dritten Teilschritt eine Nachbehandlung der zuvor abgeschiedenen Teilschicht erfolgen.

Die Änderung der Abscheideparameter kann dabei in verschiedenen Teilschritten schrittweise erfolgen. In einer anderen Variante des erfindungsgemäßen Verfahrens wird der veränderliche Abscheideparameter in wenigstens einem Teilschritt kontinuierlich vergrößert oder verkleinert. In dieser Variante des Verfahrens erfolgt keine sprunghafte Änderung eines oder mehrerer Abscheideparameter, sondern dessen oder deren kontinuierliche Veränderung. Diese Veränderung kann in einer allmählichen Vergrößerung oder einer allmählichen Reduzierung des veränderten Parameters bestehen. Die kontinuierliche Veränderung von Abscheideparametern kann dabei gezielt eingesetzt werden, beispielsweise um einen Gradienten in der entsprechenden Wirkung zu erreichen. Die kontinuierliche Veränderung kann sich jedoch auch aus gegebenen technischen Randbedingungen ergeben. Beispielsweise kann die Konzentration eines Stoffes in einer Abscheidekammer nicht sprungartig geändert werden, sondern die Konzentration kann nur mit begrenzten Änderungsgeschwindigkeiten reduziert oder erhöht werden.

In einer besonders bevorzugten Ausführungsform des erfindungsgemäßen Verfahrens werden in einem ersten Teilschritt des Plasmaentladungsprozesses zur Abscheidung der Passivierungsschicht ein Siliziumpräkursorgasfluss und ein Wasserstoffgasfluss in eine Prozesskammer geleitet, und in einem zweiten Teilschritt wird ein Plasma gezündet, wobei das Plasma mit einem Anfangs-Leistungspuls gezündet wird, der ausreichend groß ist, um ein epitaktisches Wachstum der Passivierungsschicht auf dem kristallinen Siliziumkern zu verhindern. Die Plasmaleistung hat einen direkten Einfluss auf die Abscheidegeschwindigkeit des plasmaunterstützten Abscheideprozesses. Bei großen Abscheidegeschwindigkeiten wird ein epitaktisches Wachstum auf einem Siliziumkristall zunehmend unwahrscheinlicher. Wenn ein epitaktisches Wachstum nicht erwünscht ist, beispielsweise weil eine amorphe oder eine nanokristalline Schicht hergestellt werden soll, kann mithilfe der Plasmaleistung daher eine definierte Anfangsabscheidung mit der gewünschten Kristallinität erreicht werden. Die Ausbildung eines Pulses kann technisch mit einer sehr kurzen Pulszeit und definierten Pulsparametern gelöst werden, sodass trotz der hohen verwendeten Leistung eine sehr kleine Schichtdicke mit geringen Abweichungen von einer Zieldicke abgeschieden wird. Die abgeschiedene Schichtdicke während des Impulses kann beispielsweise weniger als eine Monolage oder im Bereich von wenigen Monolagen liegen. Die konkreten technischen Charakterisierungsgrößen des Leistungspulses hängen von einer Reihe von Faktoren ab, beispielsweise von den verwendeten Materialien, der Reinheit der Oberfläche und der verwendeten Plasmaquelle. Der auf dem Gebiet der Plasmaabscheidung arbeitende Fachmann ist jedoch aufgrund seiner Fachkenntnisse in der Lage, den Anfangs-Leistungspuls geeignet festzulegen.

In einer besonders bevorzugten Ausgestaltung des erfindungsgemäßen Verfahrens wird in einem Teilschritt des Plasmaentladungsprozesses zur Abscheidung der Passivierungsschicht unter Beteiligung eines Siliziumpräkursorgasflusses, eines Wasserstoff-Gasflusses und eines Plasmas eine Lage der Passivierungsschicht abgeschieden, und in einem weiteren Teilschritt werden der Wasserstoff-Gasfluss und das Plasma aufrecht erhalten, während der Siliziumpräkursorgasfluss reduziert oder abgeschaltet wird. In dieser Verfahrensvariante erfolgt lagenweise eine Abscheidung einer Schicht, beispielsweise einer Siliziumschicht oder einer Siliziumkarbidschicht, und anschließend eine Plasmabehandlung der gerade abgeschiedenen Lage der Schicht. Diese beiden Teilschritte müssen nicht scharf voneinander getrennt sein, sondern es ist auch möglich, dass in dem erstgenannten Teilschritt eine Abscheidung mit einer hohen Abscheidegeschwindigkeit erfolgt und in dem weiteren Teilschritt eine Abscheidung mit einer geringen Abscheidegeschwindigkeit erfolgt, sodass der Wasserstoffbehandlungseffekt diesen Teilschritt dominiert und während der Wasserstoffbehandlung dennoch eine geringe weitere Abscheidung erfolgt. Die genaue Durchführung des Verfahrens ist von vielen Faktoren abhängig und kann von einem verantwortlichen Fachmann auf Grundlage seiner Fachkenntnisse konkretisiert werden.

In einer Weiterbildung dieser Verfahrensausgestaltung wird der Plasmaentladungsprozess zur Abscheidung der Passivierungsschicht als ein Lage-auf-Lage-Schichtherstellungsverfahren durchgeführt, wobei die Abfolge aus den beiden genannten Teilschritten wenigstens einmal wiederholt wird. Durch das Lage-auf-Lage-Herstellungsverfahren kann die Qualität jeder Lage beispielsweise durch eine Wasserstoffplasmanachbehandlung realisiert werden, und durch das Aufeinanderbringen mehrerer Lagen kann eine gewünschte Schichtdicke in der gewünschten Qualität erzeugt werden.

Bevorzugte Ausführungsformen der vorliegenden Erfindung, deren Aufbau, Funktion und Vorteile sollen im Folgenden an Hand von Figuren weiter erläutert werden, wobei

Figur 1   schematisch einen Querschnitt einer erfindungsgemäß hergestellten Solarzelle zeigt;

Figur 2   ein an einer Solarzelle gemessenes Infrarotabsorptionsspektrum mit Modellkurven zeigt; und

Figur 3   schematisch eine mögliche erfindungsgemäße Prozessabfolge zur Herstellung einer Passivierungsschicht auf einem kristallinen Siliziumkern zeigt.

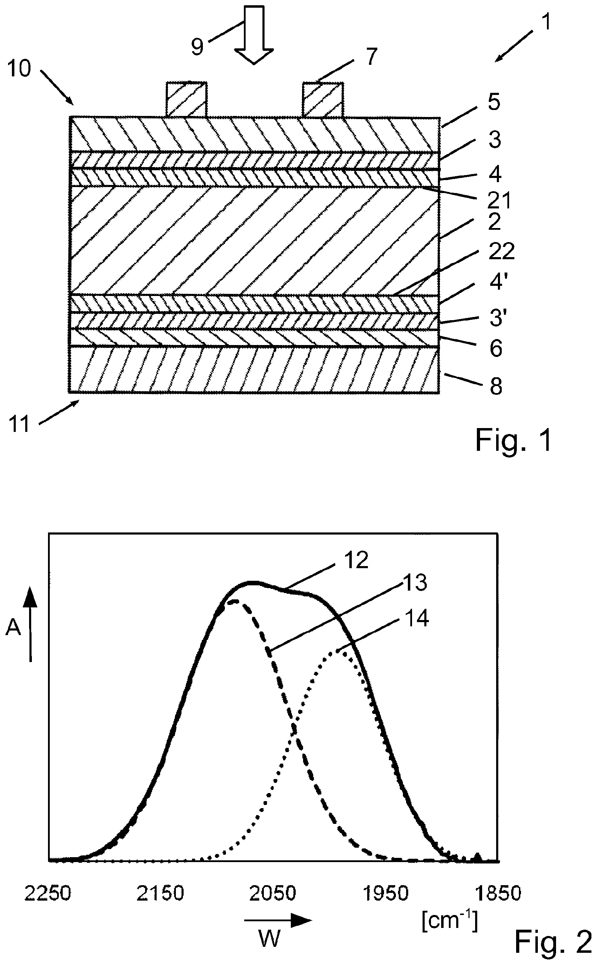

Figur 1 zeigt ein Ausführungsbeispiel einer erfindungsgemäß hergestellten Solarzelle 1 in einer schematischen Querschnittsdarstellung. Die Proportionen der einzelnen Elemente der Solarzelle 1 sind zur Darstellung geeignet skizziert, wobei die einzelnen Elemente nicht maßstäblich dargestellt sind. Die dargestellte Solarzelle 1 weist einen kristallinen Siliziumkern 2 auf, der im dargestellten Ausführungsbeispiel p-dotiert ist. In anderen, nicht dargestellten Ausführungsbeispielen der vorliegenden Erfindung kann der kristalline Siliziumkern 2 auch n-dotiert oder intrinsisch, also nicht mit Akzeptoren oder Donatoren dotiert, sein. In dem in Figur 1 dargestellten Ausführungsbeispiel einer erfindungsgemäßen Solarzelle 1 sind desweiteren zwei dotierte Silizium- oder Siliziumlegierungsschichten 3 und 3' vorhanden, wobei die Silizium- oder Siliziumlegierungsschicht 3 invers zu dem kristallinen Siliziumkern 2, in dem dargestellten Ausführungsbeispiel also n-dotiert ist. Die dotierte Halbleiterschicht 3' ist hingegen p-dotiert, wobei die Dotierung in der dotierten Silizium- oder Siliziumlegierungsschicht 3' größer ist als in dem p-dotierten kristallinen Siliziumkern 2. Zwischen dem kristallinen Siliziumkern 2 und den dotierten Silizium- oder Siliziumlegierungsschichten 3 und 3' befindet sich jeweils eine Passivierungsschicht 4, die in dem dargestellten Ausführungsbeispiel eine intrinsische hydrogenisierte amorphe Siliziumschicht ist.

Die Solarzelle 1 würde prinzipiell auch dann funktionieren, wenn die Passivierungsschichten 4 und 4' weggelassen werden würden. in diesem Fall würden zwischen dem kristallinen Siliziumkern 2 und den dotierten Silizium- oder Siliziumlegierungsschichten 3, 3' Grenzflächen vorhanden sein. Die Passivierungsschichten 4, 4' sind hydrogenisierte Siliziumschichten, in die viel Wasserstoff eingebaut ist. Der Wasserstoff ist dabei zum großen Teil unter Ausbildung von Silizium-Di-Hydrid-Molekülgruppen an Siliziumatome gebunden, wobei das Verhältnis Q von Silizium-Di-Hydrid-Bindungen zu der Summe aus Silizium-Di-Hydrid- und Silizium-Mono-Hydrid-Bindungen größer als 0,4 ist.

Der in Silizium-Di-Hydrid-Molekülgruppen vorliegende Wasserstoff hat sich als ein Schlüssel zum Erreichen sehr gut passivierter Solarzellen herausgestellt. Unter Passivierung wird die Absättigung von freien Bindungsplätzen, den sogenannten "dangling bonds", verstanden, die beispielsweise durch die Bindung von Wasserstoff an diese Bindungsplätze erfolgt. Die Solarzelle mit an Silizium-Di-Hydrid reichen Grenzflächen, die durch die Passivierungsschichten 4, 4' ausgebildet werden, zeichnen sich durch vorteilhafte elektrische Kenngrößen, wie beispielsweise eine hohe Leerlaufspannung ($V_{oc}$) und einen kleinen inversen Dunkelstrom, und insgesamt durch einen großen photoelektrischen Wirkungsgrad aus.

In dem in Figur 1 dargestellten Ausführungsbeispiel einer Solarzelle 1 erfolgt der äußere Anschluss der Solarzelle 1 auf der Vorderseite 10 der Solarzelle 1 über eine transparente leitfähige Oxidschicht 5 und über metallische Vorderseitenkontakte 7. Die Vorderseite 10 ist dabei als die Seite der Solarzelle 1 definiert, auf die der Einfall von Solarstrahlung 9 vorgesehen ist. Auf ihrer Rückseite weist die Solarzelle 1 in dem in Figur 1 dargestellten Ausführungsbeispiel zur Kontaktierung eine transparente leitfähige Rückseitenoxidschicht 6 und einen vollflächigen Rückseitenkontakt 8 auf. Der Rückseitenkontakt 8 ist eine metallische Schicht, die neben der elektrischen Kontaktierung auch eine Reflexion von dem Licht bewirkt, das ungenutzt durch die Solarzelle 1 transmittiert wurde.

Neben dem dargestellten Typ eines Ausführungsbeispiels der Solarzelle 1 existieren viele weitere, nicht dargestellte Ausführungsbeispiele erfindungsgemäß herstellbarer Solarzellen. In einem nicht dargestellten Ausführungsbeispiel einer Solarzelle 1 sind beispielsweise alle Kontakte auf der Rückseite 11 der Solarzelle 1 angeordnet, wobei dann lokale Dotierungen und Kontaktierungen des kristallinen Siliziumkerns 2 und der p- oder n-dotierten Silizium- oder Siliziumlegierungsschicht 3, 3' erforderlich sind.

In einem anderen, nicht dargestellten Ausführungsbeispiel der erfindungsgemäß hergestellten Solarzelle 1 ist die Solarzelle 1 als sogenannte Tandemsolarzelle ausgebildet, bei der auf der Vorderseite einer ersten Solarzelle eine weitere Solarzelle so ausgebildet ist, deren spektrale Empfindlichkeit sich von der ersten Solarzelle unterscheidet und die einen eigenen pn-Übergang oder pin-Übergang aufweist.

Figur 2 zeigt ein Beispiel eines gemessenen Infrarotabsorptionsspektrums 12, das an einer Ausführungsform einer Solarzelle 1 gemessen wurde. Dabei ist die Infrarotabsorption (absorbance) A über der Wellenzahl (wavenumber) W aufgetragen. Das gemessene Absorptionsspektrum 12 kann mit Hilfe einer Modellkurve für die Si-H$_2$-Infrarotabsorptionslinie bei einer Wellenzahl von 2080 +/- 20 cm$^{-1}$ und einer Infrarotabsorptionslinie von Si-H-Molekülgruppen bei einer Wellenzahl von 2000 +/- 20 cm$^{-1}$ interpretiert werden. Aus dem Größenverhältnis dieser Flächen kann ein Q-Faktor gemäß

$$ Q = \frac{n_{Si-H2}}{n_{Si-H2} + n_{Si-H}} > 0,4 $$

berechnet werden, der, wenn er größer als 0,4 ist, charakteristisch für die Solarzellen 1 ist. Es ist ganz besonders von Vorteil, wenn der Faktor Q auf einem Wert oberhalb von 0,5 eingestellt werden kann. Noch bessere Ergebnisse wurden bei Werten für Q oberhalb von 0,6 ermittelt. Je höher der Faktor Q, umso bessere Passivierungseigenschaften der Passivierungsschicht(en) 4, 4' und konnten ermittelt werden, was sich entsprechend positiv auf die Effizienz(en) der erfindungsgemäß herstellbaren Solarzelle(n) auswirkt.

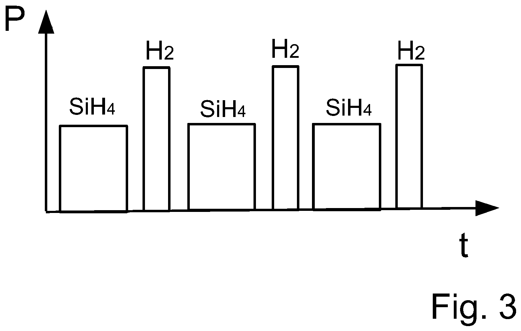

Figur 3 zeigt schematisch eine mögliche Abfolge einer plasmagestützten Schichtabscheidung zur Herstellung einer hydrogenisierten Passivierungsschicht 4, 4' auf einem einkristallinen Siliziumkern 2. Die Darstellung in Figur 3 zeigt die Leistung P in Relation zu der Prozesszeit t. Hierbei erfolgt eine alternierende Abfolge aus Silan-Plasmaabscheidungsschritten und H$_2$-Plasmabehandlungsschritten. In dem gezeigten Ausführungsbeispiel, welches lediglich beispielhaft aber nicht einschränkend bezüglich der verwendeten Schrittzahl, -länge und -abfolge und verwendeter Leistung aufgeführt ist, wurde der Abscheideprozess in drei kürzere Silan-Plasmaschichtabscheidungsschritte gesplittet, welche jeweils von H$_2$-Plasmabehandlungsschritten gefolgt wurden. Durch diese Vorgehensweise wird die Wasserstoffkonzentration in der Passivierungsschicht erhöht, wodurch insbesondere die Grenzfläche zwischen kristallinem Substrat und Passivierungsschicht gut mit Wasserstoff gesättigt werden kann, was wiederum zu einer deutlichen Verbesserung der Passivierungseigenschaften der Passivierungsschicht 4, 4' führt. Auch ohne nachfolgende Temperung bzw. bei geringer nachfolgender Temperzeit kann durch eine Prozessführung, wie sie in Figur 3 schematisch dargestellt ist, eine deutliche Erhöhung der Minoritätsträgerlebensdauer erreicht werden.

**Patentansprüche**

1. Verfahren zur Herstellung einer Solarzelle (1) mit

 - einem kristallinen Siliziumkern (2),
 - wenigstens einer n- oder p-dotierten Silizium- oder Siliziumlegierungsschicht (3, 3') und
 - wenigstens einer aus Silizium oder einer Siliziumlegierung bestehenden Passivierungsschicht (4, 4') zwischen wenigstens einer Oberfläche (21, 22) des Siliziumkerns (2) und der wenigstens einen n- oder p-dotierten Silizium- oder Siliziumslegierungsschicht (3, 3'), wobei

die Passivierungsschicht (4, 4')derart abgeschieden wird, dass die produzierte Passivierungsschicht (4, 4') Silizium-Mono-Hydrid-Molekülgruppen (Si-H) und Silizium-Di-Hydrid-Molekülgruppen (Si-H$_2$) aufweist und ein Verhältnis (Q) der Anzahl von Silizium-Di-Hydrid-Molekülgruppen (n$_{Si-H2}$) zu der Gesamtanzahl von Silizium-Di-Hydrid-Molekülgruppen (n$_{Si-H2}$) und Silizium-Mono-Hydrid-Molekülgruppen (n$_{Si-H}$) in einem Vergleichsvolumen der Passivierungsschicht (4, 4') größer als 0,4 ist

$$ \left( Q = \frac{n_{Si-H2}}{n_{Si-H2} + n_{Si-H}} > 0,4 \right), $$ wobei die Passivierungsschicht (4, 4') in mehreren Teilschritten eines Plasmaentladungsprozesses abgeschieden wird, **dadurch gekennzeichnet, dass** in einer ersten Variante des Verfahrens bei der Abscheidung der Passivierungsschicht (4, 4') eine alternierende Abfolge von Silan-Plasmaabscheidungsschritten und H$_2$-Plasmabehandlungsschritten angewendet wird
oder
in einer zweiten Variante des Verfahrens bei der Abscheidung der Passivierungsschicht (4, 4') während aller Teilschritte des Plasmaentladungsprozesses ein kontinuierlich brennendes auf die Passivierungsschicht (4, 4') einwirkendes Plasma verwendet wird und in einem Folge-Teilschritt des Plasmaentladungsprozesses zur Abscheidung der Passivierungsschicht (4, 4'), der einem Vorgänger-Teilschritt dieses Plasmaentladungsprozesses folgt, wenigstens ein veränderbarer Abscheideparameter, ausgewählt aus den Abscheideparametern Prozessdruck, elektrische Leistung und Präkursorgasfluss, im Vergleich zu dem jeweils entsprechenden Abscheidungsparameter des Vorgänger-Teilschrittes geändert wird.

**2.** Verfahren nach Anspruch 1, **dadurch gekennzeichnet, dass** bei der Abscheidung der n- oder p-dotierten Silizium- oder Siliziumlegierungsschicht (3, 3') und/oder der Passivierungsschicht (4, 4') wenigstens zeitweise ein KohlenstoffPräkursor eingesetzt wird, wobei durch den Einsatz des Kohlenstoff-Präkursors die erzeugte n- oder p-dotierte Silizium- oder Siliziumlegierungsschicht (3, 3') und/oder die Passivierungsschicht (4, 4') Kohlenstoffatome in Si-C-Bindungen aufweist.

**3.** Verfahren nach Anspruch 1 oder 2, **dadurch gekennzeichnet, dass** bei der Abscheidung der n- oder p-dotierten Silizium- oder Siliziumlegierungsschicht (3, 3') und/oder der Passivierungsschicht (4, 4') wenigstens zeitweise ein SauerstoffPräkursor eingesetzt wird, wobei durch den Einsatz des Sauerstoff-Präkursors, die erzeugte n- oder p-dotierte Silizium- oder Siliziumlegierungsschicht (3, 3') und/oder die Passivierungsschicht (4, 4') Sauerstoffatome in Si-O-Bindungen aufweist.

**4.** Verfahren nach wenigstens einem der vorhergehenden Ansprüche, **dadurch gekennzeichnet, dass** in der zweiten Variante des Verfahrens der wenigstens eine veränderbare Abscheideparameter in wenigstens einem Teilschritt des Plasmaentladungsprozesses kontinuierlich vergrößert oder verkleinert wird.

**5.** Verfahren nach wenigstens einem der vorhergehenden Ansprüche, **dadurch gekennzeichnet, dass** in der zweiten Variante des Verfahrens in einem ersten Teilschritt des Plasmaentladungsprozesses zur Abscheidung der Passivierungsschicht (4, 4') ein Silizium-Präkursor-Gasfluss und ein Wasserstoff-Gasfluss in eine Prozesskammer geleitet werden und in einem zweiten Teilschritt dieses Plasmaentladungsprozesses ein Plasma gezündet wird, wobei das Plasma mit einem Anfangs-Leistungspuls gezündet wird, der ausreichend groß ist, um ein epitaktisches Wachstum der Passivierungsschicht (4, 4') auf dem kristallinen Siliziumkern (2) zu verhindern.

**6.** Verfahren nach Anspruch 4 oder 5, **dadurch gekennzeichnet, dass** in einem Teilschritt des Plasmaentladungsprozesses zur Abscheidung der Passivierungsschicht (4, 4') unter Beteiligung eines Silizium-Präkursor-Gasflusses, eines Wasserstoff-Gasflusses und eines Plasmas eine Lage der Passivierungsschicht (4, 4') abgeschieden wird und in einem weiteren Teilschritt des Plasmaentladungsprozesses der Wasserstoff-Gasfluss und das Plasma aufrecht erhalten werden, während der Silizium-Präkursor-Gasfluss reduziert oder abgeschaltet wird.

**7.** Verfahren nach Anspruch 6, **dadurch gekenn-**

**zeichnet, dass** der Plasmaentladungsprozess zur Abscheidung der Passivierungsschicht (4, 4') als ein Lage-aufLage-Schichtherstellungsprozess durchgeführt wird, wobei die Abfolge aus den beiden Teilschritten wenigstens einmal wiederholt wird.

**Claims**

**1.** Method for producing a solar cell (1) comprising

- a crystalline silicon core (2),
- at least one n- or p-doped silicon or silicon alloy layer (3, 3') and
- at least one passivation layer (4, 4') consisting of silicon or a silicon alloy between at least one surface (21, 22) of the silicon core (2) and the at least one n- or p-doped silicon or silicon alloy layer (3, 3'), wherein

the passivation layer (4, 4') is deposited in such a way that the passivation layer (4, 4') produced comprises silicon monohydride molecular groups (Si-H) and silicon dihydride molecular groups (Si-H$_2$) and that a ratio (Q) of the number of silicon dihydride molecular groups (n$_{Si-H2}$) to the total number of silicon dihydride molecular groups (n$_{Si-H2}$) and silicon monohydride molecular groups (n$_{Si-H}$) is greater than 0.4 in a comparison volume of the passivation layer (4, 4') $\left( Q = \frac{n_{Si-H2}}{n_{Si-H2}+n_{Si-H}} > 0.4 \right)$, wherein the passivation layer (4, 4') is deposited in a plurality of sub-steps of a plasma discharge process, **characterized in that,**
in a first variant of the method, during the deposition of the passivation layer (4, 4'), an alternating sequence of silane plasma deposition steps and H$_2$ plasma treatment steps are used
or,
in a second variant of the method, during the deposition of the passivation layer (4, 4'), a continuously burning plasma acting on the passivation layer (4, 4') is used during all sub-steps of the plasma discharge process, and in a subsequent sub-step of the plasma discharge process for the deposition of the passivation layer (4, 4'), which follows a previous sub-step of this plasma discharge process, at least one changeable deposition parameter, selected from the deposition parameters of process pressure, electrical power and precursor gas flow, is changed by comparison with the corresponding deposition parameter of the previous sub-step in each case.

**2.** Method according to claim 1, **characterized in that** a carbon precursor is used at least temporarily during the deposition of the n- or p-doped silicon or silicon alloy layer (3, 3') and/or the passivation layer (4, 4'), wherein, through the use of the carbon precursor, the n- or p-doped silicon or silicon alloy layer (3, 3') and/or the passivation layer (4, 4') produced comprises carbon atoms in Si-C bonds.

3. Method according to claim 1 or 2, **characterized in that** an oxygen precursor is used at least temporarily during the deposition of the n- or p-doped silicon or silicon alloy layer (3, 3') and/or the passivation layer (4, 4'), wherein, through the use of the oxygen precursor, the n- or p-doped silicon or silicon alloy layer (3, 3') and/or the passivation layer (4, 4') produced comprises oxygen atoms in Si-O bonds.

4. Method according to at least one of the preceding claims, **characterized in that,** in the second variant of the method, the at least one changeable deposition parameter is continuously increased or decreased in at least one sub-step of the plasma discharge process.

5. Method according to at least one of the preceding claims, **characterized in that,** in the second variant of the method, a silicon precursor gas flow and a hydrogen gas flow are passed into a process chamber in a first substep of the plasma discharge process for the deposition of the passivation layer (4, 4') and a plasma is ignited in a second sub-step of this plasma discharge process, wherein the plasma is ignited with an initial power pulse which is sufficiently large to prevent epitaxial growth of the passivation layer (4, 4') on the crystalline silicon core (2).

6. Method according to claim 4 or 5, **characterized in that,** in a sub-step of the plasma discharge process for the deposition of the passivation layer (4, 4') involving a silicon precursor gas flow, a hydrogen gas flow and a plasma, a layer of the passivation layer (4, 4') is deposited and, in a further sub-step of the plasma discharge process, the hydrogen gas flow and the plasma are maintained while the silicon precursor gas flow is reduced or cut off.

7. Method according to claim 6, **characterized in that** the plasma discharge process for the deposition of the passivation layer (4, 4') is carried out as a layer-on-layer production process, with the sequence of the two sub-steps being repeated at least once.

**Revendications**

1. Procédé de fabrication d'une cellule photovoltaïque (1) comportant

    - un noyau de silicium cristallin (2),
    - au moins une couche de silicium ou d'alliage de silicium dopée n ou p (3, 3') et
- au moins une couche de passivation (4, 4') constituée de silicium ou d'un alliage de silicium entre au moins une surface (21, 22) du noyau de silicium (2) et l'au moins une couche de silicium ou d'alliage de silicium dopée n ou p (3, 3'),

la couche de passivation (4, 4') étant déposée de telle sorte que la couche de passivation (4, 4') produite comporte des groupes de molécules de monohydrure de silicium (Si-H) et des groupes de molécules de dihydrure de silicium (Si-H$_2$) et qu'un rapport (Q) entre le nombre de groupes de molécules de dihydrure de silicium ($n_{Si-H2}$) et le nombre total de groupes de molécules de dihydrure de silicium ($n_{Si-H2}$) et de groupes de molécules de monohydrure de silicium ($n_{Si-H}$), dans un volume de comparaison de la couche de passivation (4, 4'), est supérieur à

$$0,4 \ \left( Q = \frac{n_{Si-H2}}{n_{Si-H2}+n_{Si-H}} > 0,4 \right),$$ la couche de passivation (4, 4') étant déposée en plusieurs sous-étapes d'un processus de décharge de plasma, **caractérisé en ce que** dans une première variante du procédé, lors du dépôt de la couche de passivation (4, 4'), une séquence alternée d'étapes de dépôt de plasma silane et d'étapes de traitement de plasma H$_2$ est utilisée, ou,

dans une seconde variante du procédé, lors du dépôt de la couche de passivation (4, 4'), pendant toutes les sous-étapes du processus de décharge de plasma, un plasma en combustion continue agissant sur la couche de passivation (4, 4') est utilisé, et dans une sous-étape ultérieure du processus de décharge de plasma permettant le dépôt de la couche de passivation (4, 4'), laquelle sous-étape fait suite à une sous-étape précédente dudit processus de décharge de plasma, au moins un paramètre de dépôt modifiable, sélectionné parmi les paramètres de dépôt que sont la pression de processus, la puissance électrique et le flux de gaz précurseur, est modifié par comparaison avec le paramètre de dépôt correspondant respectif de la sous-étape précédente.

2. Procédé selon la revendication 1, **caractérisé en ce qu'**un précurseur de carbone est utilisé au moins temporairement lors du dépôt de la couche de silicium ou d'alliage de silicium dopée n ou p (3, 3') et/ou de la couche de passivation (4, 4'), la couche de silicium ou d'alliage de silicium dopée n ou p (3, 3') et/ou la couche de passivation (4, 4') produites grâce à l'utilisation du précurseur de carbone comportant des atomes de carbone dans des liaisons Si-C.

3. Procédé selon la revendication 1 ou 2, **caractérisé**

**en ce qu'**un précurseur d'oxygène est utilisé au moins temporairement lors du dépôt de la couche de silicium ou d'alliage de silicium dopée n ou p (3, 3') et/ou de la couche de passivation (4, 4'), la couche de silicium ou d'alliage de silicium dopée n ou p (3, 3') et/ou la couche de passivation (4, 4') produites grâce à l'utilisation du précurseur d'oxygène comportant des atomes d'oxygène dans des liaisons Si-O.

4. Procédé selon au moins l'une des revendications précédentes, **caractérisé en ce que**, dans la seconde variante du procédé, l'au moins un paramètre de dépôt modifiable est augmenté ou diminué en continu dans au moins une sous-étape du processus de décharge de plasma.

5. Procédé selon au moins l'une des revendications précédentes, **caractérisé en ce que** dans la seconde variante du procédé, dans une première sous-étape du processus de décharge de plasma permettant le dépôt de la couche de passivation (4, 4'), un flux de gaz précurseur de silicium et un flux de gaz d'hydrogène sont guidés dans une chambre de processus, et, dans une seconde sous-étape de ce processus de décharge de plasma, un plasma est allumé, le plasma étant allumé avec une impulsion de puissance initiale qui est suffisamment grande pour empêcher la croissance épitaxiale de la couche de passivation (4, 4') sur le noyau de silicium cristallin (2).

6. Procédé selon la revendication 4 ou 5, **caractérisé en ce que**, dans une sous-étape du processus de décharge de plasma permettant le dépôt de la couche de passivation (4, 4') en présence d'un flux de gaz précurseur de silicium, d'un flux de gaz d'hydrogène et d'un plasma, une nappe de la couche de passivation (4, 4') est déposée, et, dans une sous-étape supplémentaire du processus de décharge de plasma, le flux de gaz d'hydrogène et le plasma sont maintenus tandis que le flux de gaz précurseur de silicium est réduit ou coupé.

7. Procédé selon la revendication 6, **caractérisé en ce que** le processus de décharge de plasma permettant le dépôt de la couche de passivation (4, 4') est réalisé comme un processus de fabrication de couche de type nappe sur nappe, la séquence constituée des deux sous-étapes étant répétée au moins une fois.

Fig. 1

Fig. 2

Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 1460693 B1

- US 7030413 B2

### In der Beschreibung aufgeführte Nicht-Patentliteratur

- **HYUN JIN YANG ; KWANG-SUN JI ; JUNGHOON CHOI ; HEON MIN LEE.** Annealing effect on surface passivation of a-Si:H/c-Si interface in terms of crystalline volume fraction. *Current Applied Physics,* 2010, vol. 10, S375-S378
- **VON FUJIWARA et al.** Optimization of interface structures in crystalline silicon heterojunction solar cells. *Solar Energy Materials & Solar Cells,* 2009, vol. 93, 725-728
- Interface structure in a-Si:H/C-Si heterojunction solar cells characterized by optical diagnosis technique. **VON FUJIWARA et al.** Conference Record of the 2006 IEEE 4th World Conference on Photovoltaic Energy Conversion. IEEE, Mai 2006, 1443-1448

- **VON J. MITCHELL.** Surface passivation of multi-crystalline silicon by multilayer deposition of hydrogenated amorphous silicon. *Proceedings of the 24th European Photovoltaic Solar Energy Conference,* 21. September 2009, 1569-1573
- **VON MAN-CHI HUANG et al.** The effect of H2 treatment on heterojunction with intrinsic thin layer (HIT) solar cell performance using 40.68 MHz VHF-PECVD system. *37th Photovoltaic Specialists Conference,* 19. Juni 2011, 3001-3004
- **VON T. MUELLER et al.** Investigation of the emitter band gap widening of heterojunction solar cells by use of hydrogenated amorphous carbon silicon alloys. *Journal of Applied Physics,* 04. Oktober 2007, vol. 102 (7), 74505